Europäisches Patentamt

European Patent Office

Office européen des brevets

(11) Publication number : **0 453 236 B1**

(12) **EUROPEAN PATENT SPECIFICATION**

(45) Date of publication of patent specification :
23.06.93 Bulletin 93/25

(51) Int. Cl.⁵ : **B60R 21/32, B60R 16/02**

(21) Application number : **91303377.5**

(22) Date of filing : **16.04.91**

(54) **Apparatus for detecting the existence of an abnormality in a vehicle operator protection system.**

(30) Priority : **16.04.90 JP 100131/90**

(43) Date of publication of application :
**23.10.91 Bulletin 91/43**

(45) Publication of the grant of the patent :
**23.06.93 Bulletin 93/25**

(84) Designated Contracting States :
**DE FR GB**

(56) References cited :
**EP-A- 0 343 578**
**EP-A- 0 344 788**
**WO-A-89/04779**

(56) References cited :
**DE-A- 3 743 961**
**DE-A- 3 802 159**
**DE-A- 3 806 694**
**US-A- 4 287 431**

(73) Proprietor : **NIPPONDENSO CO., LTD.**
**1-1, Showa-cho**
**Kariya-city Aichi-pref., 448 (JP)**

(72) Inventor : **Kondo, Akira**
**5-1-7, Hanekita-cho**
**Okazaki-city, Aichi-pref. (JP)**

(74) Representative : **Dempster, Benjamin John**
**Naftel et al**
**Withers & Rogers 4 Dyer's Buildings, Holborn**
**London EC1N 2JT (GB)**

EP 0 453 236 B1

## Description

The present invention relates to a vehicle occupant protection system such as an air bag system and more particularly to the art of determining the existence of an abnormality in a backup circuit for positively supplying power to the actuating device for actuating the protection system.

In a conventional air bag system, charging means (for example, a backup capacitor) is connected in parallel with an actuating device of the air bag system, to make sure that the air bag system would be actuated even if the battery of the vehicle becomes inoperable in a collision or the like.

The backup capacitor is charged during normal operation and if the battery becomes inoperable in a collision or the like, the backup capacitor discharges to energize the actuating device in place of the battery.

Therefore static capacitance of the backup capacitor is required to determine whether or not it is capable of storing a charge necessary to actuate the actuating device.

EP-A-0344788 discloses a vehicle occupant protection system comprising a battery supplying a squib which inflates an air bag. A lock up capacitor is provided in the circuit to supply the squib in the event that the current from the battery is insufficient. A microcomputer is provided which actuates a warning lamp if at least one of the squib, a mercury acceleration switch and a transistor malfunctions.

JP-B-44912/1980 discloses that

(1) the period for the backup capacitor to attain given voltage is compared with the criterion time when the backup capacitor is connected to the battery, or

(2) the time-charging voltage characteristics diagram of the circuit having standard time constant is compared with the time-charging voltage characteristics diagram when the standard time constant circuit is provided especially.

According to the prior art, any deterioration either in the performance of the backup capacitor itself, or in the performance of the charging of the backup capacitor (for example, performance deterioration due to increase of leakage resistance) can be determined.

However, the backup capacitor is provided to maintain a voltage sufficient to positively actuate the air bag device, when the battery fails for whatever reason or the battery terminal becomes disconnected. Therefore, it is necessary to detect any abnormality in the static capacitance that may prevent reliable actuation.

From such a point of view, when the backup capacitor is charged by the battery voltage and the time taken to attain a given voltage would be compared with a criterion time as in the prior art, since the backup capacitor connected to the battery is susceptible to variation of the battery voltage, high precision abnormality determination of the static capacitance of the backup capacitor can not be effected.

Also in the case of comparing a variation of charging voltage in a standard time constant circuit being provided with a variation of charging voltage of the backup capacitor, special expensive elements have been used, as it was necessary to use elements having low temperature and little aged change in order to prepare the standard time constant circuit.

One object of the present invention is to enable without using special elements and even under voltage variation of an onboard battery, determination of an abnormality in charging account being performed taken battery voltage variations so that even if the power supply to the actuating means is interrupted, positive actuation of the vehicle operator protection system is possible.

According to the present invention, a vehicle occupant protection system comprises means connected or for connection to a battery, for actuating vehicle operator protection, auxiliary power supply means chargeable by a battery and dischargeable to supply the electric power to the actuator means when the electric power supply from the battery to the actuator means is interrupted, characterised in that the system further includes determining means for detecting a charging voltage of the auxiliary power supply means and a battery voltage during charging of the auxiliary power supply means, for determining a chargeability of the auxiliary power supply means under varying conditions independent of battery voltage variation, and for determining abnormality of the auxiliary power supply means on the basis of the said chargeability.

Embodiments of the present invention will now be described by way of example with reference to the accompanying drawings in which:

Figure 1 is a circuit diagram of an embodiment of the present invention;

Figure 2 is a flow chart illustration determination of an abnormality in static capacity by a microcomputer shown in Figure 1;

Figure 3 is a flow charge showing a whole operation of the micro-computer shown in Figure 1;

Figure 4 is a time chart showing the voltage fluctuation of a capacitor and a charging power supply used to explain the above-mentioned embodiment;

Figure 5 is a flow chart similar to Figure 2 but of another embodiment; and

Figure 6 is a circuit diagram of a further embodiment in which an apparatus according to the present invention is constructed by an analog circuit.

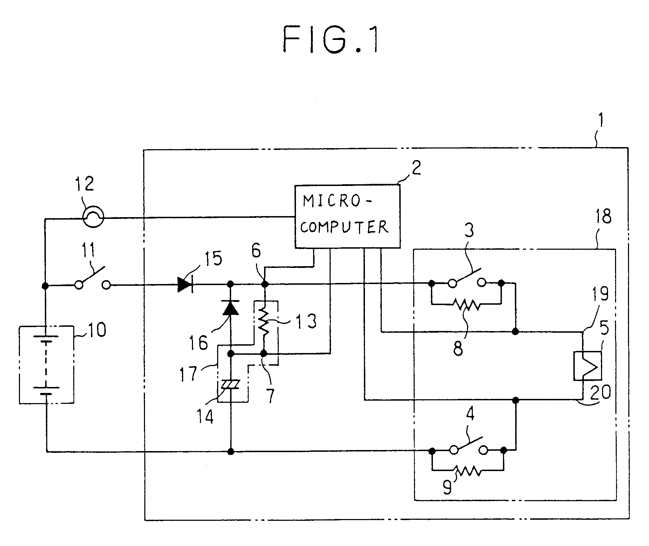

In the embodiment of Figures 1 to 4, at the backup capacitor constituting a time constant circuit and connected in parallel with an actuator actuating the air bag system, the voltage difference between the onboard battery and the backup capacitor is integrated for a given period in charging of the backup capacitor. Determination of abnormality in static capacitance of the backup capacitor is based on the value derived from dividing the above integral value by increased potential value of the backup capacitor in a given period.

In Figure 1, a battery 10 is connected to an ignition switch 11 linked with a key switch (not shown), an air bag system 1 providing vehicle operator operation protection, and an indicator lamp 12 informing any vehicle operator of the failures of the air bag system 1.

An acceleration detection switch 3 is turned on when acceleration to the vehicle is beyond a predetermined value. The acceleration switch 3 is provided in parallel with a resistor 8. Another acceleration detection switch 4 is provided in parallel with a resistor 9. Then, the acceleration detection switch 3 and the acceleration detection switch 4 are connected to a triggering device such as a squib 5 for inflating an air bag (not shown).

The resistor 8 and the resistor 9 are of high resistance, and supply a current insufficient to actuate the squib 5 (i.e. current is just below that required to actuate the squib) when the acceleration detection switch 3 and the acceleration detection switch 4 are turned off. The above-mentioned current is used to check for malfunction of the squib 5, the acceleration detection switch 3 and the acceleration detection switch 4, which is described later.

An actuator 18 comprises the squib 5, the acceleration detection switch 3, the resistor 8, the acceleration detection switch 4, and the resistor 9 as above described.

A backup capacitor 14 and a charging resistor 13 constitute a time constant circuit 17. The backup capacitor 14 is charged through the charging resistor 13 by charges supplied from the battery 10. The backup capacitor 14 is of large capacitance (such as approximately 4700 μF).

A diode 16 is provided so that current supplied from the battery 10 flows through the charging resistor 13 into the backup capacitor 14, and when the power supply from the battery 10 is interrupted and the backup capacitor 14 is discharged, discharge occurs quickly.

A diode 15 is provided so that current supplied from the battery 10 flows into an actuator 18, and when the backup capacitor 14 is discharged, electric charges supplied from the backup capacitor 14 are prevented from flowing into the side of the battery 10.

The voltages terminals 6 and 7 are at opposite ends of the charging resistor 13, are used for abnormality determination of static capacitance of the backup capacitor 14, being detected by the microcomputer 2.

The microcomputer 2 performs abnormality determination of static capacitance of the backup capacitor 14 on the basis of detected voltages at the terminals 6 and 7.

When the ignition switch 11 is turned on, the actuator 18 is supplied with power from the battery 10 and the backup capacitor 14 charges through the charging resistor 13.

In the event of a collision while all the circuits are in a normal condition, the acceleration detection switches 3 and 4 are turned on. As a result, a current sufficient to actuate the squib 5 is supplied from the battery 10. The squib 5 then ignites so that the air bag (not shown) is inflated.

Even if the supply of current from the battery 10 is interrupted owing to impact at the time of collision, electric charges given to the backup capacitor 14 are supplied through the diode 16 to the actuator 18, so that the air bag is inflated.

If then the ignition switch 11 is turned off with each circuit in its normal condition, the air bag system 1 will be disconnected from the battery 10. Accordingly the power supply to the actuator 18 and the backup capacitor 14 is cut-off. The backup capacitor 14 then discharges through the diode 16 and the actuator 18 as the discharge path, and decreases its own charging voltage gradually also by self discharging.

Determination of an abnormality in capacitance of the backup capacitor 14 is carried out by the microcomputer 2 as described below

Generally, charge quantity Q charged in a capacitor constituting a time constant circuit from time $t_1$ to time $t_2$ is expressed by the equation

$$Q = \int_{t_1}^{t_2} i_c(t)\, dt \qquad\qquad (1)$$

where $i_c(t)$ is the charging current of the capacitor at optional time t.

Where a voltage of a capacitor at optional time t is denoted by $V_c(t)$, a battery voltage charging the capacitor is denoted by $V_s(t)$, and a charging resistor constituting the time constant circuit together with the capacitor is

EP 0 453 236 B1

denoted by R, the charging current $i_c(t)$ is expressed by the following equation.

$$i_c(t) = \frac{V_s(t) - V_c(t)}{R} \quad (2)$$

According to equations (1) and (2),

$$Q = \frac{1}{R} \cdot \int_{t_1}^{t_2} (V_s(t) - V_c(t)) \, dt \qquad (3)$$

Where the capacitor voltage at the time $t_1$ is denoted by $V_1$, the capacitor voltage at the time $t_2$ is denoted by $V_2$, and capacitance of the capacitor is denoted by C, the charge quantity Q is expressed as follows.

$$Q = C \cdot (V_2 - V_1) \quad (4)$$

From equations (3) and (4), following equation is deduced.

$$C = \frac{1}{R} \cdot \frac{1}{V_2 - V_1} \cdot \int_{t_1}^{t_2} (V_s(t) - V_c(t)) \, dt \qquad (5)$$

As a charging resistor R is constant, the deterioration of electrostatic capacitance of the capacitor can be determined according to whether or not the integration of second and third terms on the right side of equation (5) is less than the predetermined constant.

Next, it will be explained that how the influences due to fluctuation of the battery voltage, which have been questionable by this time, are eliminated by determining the deterioration of electrostatic capacitance of the capacitor using the above-mentioned equations.

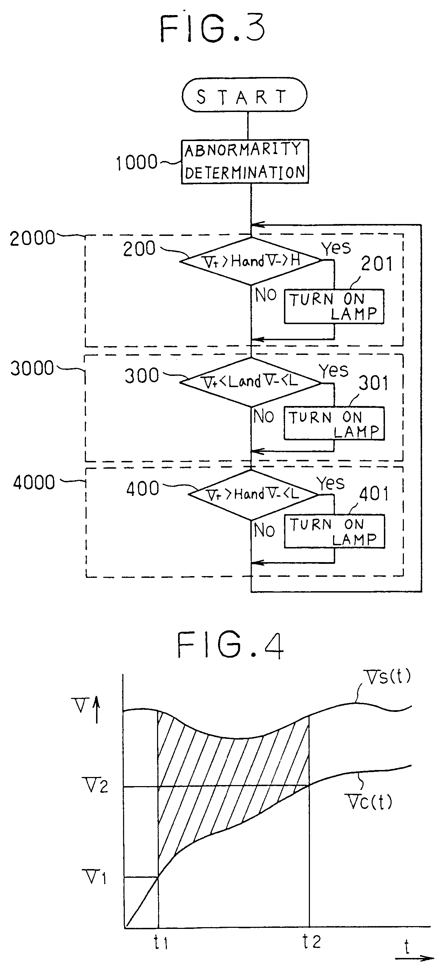

FIG. 4 is a time chart showing voltage fluctuation of the capacitor 14 and the battery 10. The area enclosed by the time $t_1$, the time $t_2$, a waveform of the charging voltage $V_s(t)$, and a waveform of the capacitor voltage $V_c(t)$ as shown by the shaded portion in FIG. 4 represents the integrated value of third term on the right side of the above-mentioned equation (5).

After the integration, when the abnormality determination of the electrostatic capacitance of the capacitor is made by the above integrated value, the enclosed area (the shaded area in FIG. 4) is nearly constant as far as the capacitor is normal, even if the capacitor voltage $V_c(t)$ also fluctuates in case there are some influences due to fluctuation of the charging voltage $V_s(t)$. Therefore, any influence due to fluctuation of the supply voltage is eliminated and the abnormality determination of electrostatic capacitance of the capacitor can be done precisely.

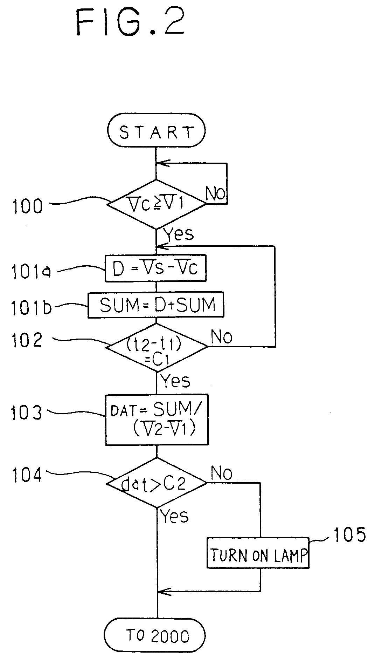

Next, based on the above-mentioned way of thinking, it will be explained how abnormality determination of capacitance of the backup capacitor 14 is performed by the microcomputer 2, based on a flow chart showing operation regarding abnormalityes determination of capacitance of the microcomputer 2 in FIG. 2 and a constitution diagram showing an embodiment of the present invention in FIG. 1.

Starting the determination process, decision is performed at step 100 as to whether or not voltage of the backup capacitor 14 is not less than a given voltage $V_1$. Where voltage $V_c$ of the backup capacitor 14 is derived by detecting voltage at the connection point 7.

If the voltage $V_c$ is less than the given voltage $V_1$, determinations at step 100 are repeated, and if $V_c$ is not less than the given voltage $V_1$, process advances to step 101a. Starting time of the abnormality determination can be set arbitrarily by the setting of the given voltage $V_1$.

At step 101a, voltage difference D is calculated between the charging voltage at that time, namely voltage $V_s$ of the battery 10 and voltage $V_c$ of the backup capacitor 14. The voltage $V_s$ of the battery 10 is derived by detecting voltage at the connection point 6, and the voltage $V_c$ of the backup capacitor 14 is derived by detecting voltage at the connection point 7. After the voltage difference D is calculated, process advances to step 101b.

At step 101b, the voltage difference D calculated at step 101a is the value SUM of arithmetic register, and process advances to step 102. The value SUM of this arithmetic register takes value 0 in the initial condition.

At step 102, decision is performed as to whether difference between the time $t_2$ from the beginning of charging up to the present and the time $t_1$ of reaching the given voltage $V_1$ at step 100 reaches a given time $C_1$ or not.

If the given time $C_1$ has not been reached, the process returns to step 101a where the voltage difference D between the voltage $V_s$ of the battery 10 and the voltage $V_c$ of the backup capacitor 14 is calculated, and then the process proceeds to step 101b. At step 101b, a sum of value SUM of the previous arithmetic register

4

and the voltage difference D calculated at this time is considered the value SUM of the arithmetic register of this time, and then the process proceeds to step 102 again. Further, the processes of step 101a, step 101b and step 102 are repeated until the given time $C_1$ has been attained. After the given time $C_1$ has been attained, the process proceeds to step 103.

The processes of step 101a, step 101b and step 102 are making an equivalent calculation to the integration described above in the third term of the right-hand side of equation (5), that is, from the time $t_1$ to the time $t_2$.

At step 103, voltage difference between the voltage $V_2$ of the backup capacitor 14 at the time $t_2$ of attaining the given time $C_1$ and the above-mentioned given voltage $V_1$ is seeked for. Value SUM of the arithmetic register at the time of attaining the given time $C_1$ is divided by the voltage difference, and the divided value is made the determination value DAT and the process proceeds to step 104. The determination value DAT is just corresponding to the integrated value derived from the second term and the third term on the right-hand side of the above-mentioned equation (5).

At step 104, decision is performed as to whether the determination value DAT obtained at step 103 is larger than a given value $C_2$ or not. As a result of the decision, if the determination value DAT is larger than the given value $C_2$, the abnormality determination of capacitance is finished. If the determination value DAT is not larger than the given value $C_2$, the process proceeds to step 105 where an indicator lamp 12 is turned on, and then the abnormality determination of capacitance is finished.

Next, whole operation of the microcomputer 2 will be explained using a flow chart showing whole operation of the microcomputer 2 in FIG. 3. Still more, block 1000 is the same as the flow chart showing operation regarding abnormality determination of capacitance of the above-mentioned microcomputer 2 in FIG. 2.

When the ignition switch 11 is turned on and abnormality determination of capacitance of the backup capacitor 14 concludes at block 1000, the process proceeds to block 2000 constituted by step 200 and step 201.

Block 2000 is a malfunction detection part of the acceleration detection switch 3. When voltage of the connection point 19 is denoted by $V_+$ and voltage of the connection point 20 is denoted by $V_-$, decision is performed as to whether the voltage $V_+$ of the connection point 19 and the voltage $V_-$ of the connection point 20 are larger than the given voltage H or not at step 200. The given voltage H is set at higher voltage than that set by each resistance value of the resistors 8 and 9, when the acceleration detection switches 3 and 4 remain off.

Then, it is shown that the acceleration detection switch 3 remains on when the voltage $V_+$ of the connection point 19 and the voltage $V_-$ of the connection point 20 are larger than this given voltage H, because of increase of voltages of the connection points 19 and 20 caused by current from the battery 10 flowing into the acceleration switch 3 having a lower resistance rather than the resistor 8 having a higher resistance when the acceleration detection switch 3 remains on.

If the voltage $V_+$ of the connection point 19 and the voltage $V_-$ of the connection point 20 are lower than the above given voltage H, the process proceeds to block 3000, and if higher than the above given voltage H, the process proceeds to step 201 so that the indicator lamp 12 can be lit and a malfunction can be notified.

On completing a malfunction detection of the acceleration detection switch 3 at the block 2000, the process proceeds to the block constituted by step 300 and step 301.

The block 3000 is a malfunction detecting portion of the acceleration detection switch 4, where decision is performed as to whether the voltage $V_+$ of the connection point 19 and the voltage $V_-$ of the connection point 20 are lower than a given voltage L or not. The given voltage L is set to lower value than the voltage set by each resistance of the resistors 8 and 9 when the acceleration detection switches 3 and 4 remain off.

Further, if the voltage $V_+$ of the connection point 19 and the voltage $V_-$ of the connection point 20 are smaller than the given voltage L, it is shown that the acceleration detection switch 4 remains on, because of decrease of voltages of the connection points 19 and 20, as current supply from the battery 10 flows into the acceleration switch 4 having a low resistance rather than the resistor 8 having a high resistance.

If the voltage $V_+$ of the connection point 19 and the voltage $V_-$ of the connection point 20 are larger than the above given voltage L, the process proceeds to block 4000, and if larger than the given voltage L, the process proceeds to step 301 so that the indicator lamp 12 can be lit and a malfunction can be notified.

At block 3000, on completing a malfunction detection of the acceleration detection switch 4, the process proceeds to the block 4000 constituted by step 400 and step 401. The block 4000 is an open failure detecting portion of the squib 5. Here, decision is performed as to whether or not the voltage $V_+$ of the connection point 19 is higher than the above given voltage H and the voltage $V_-$ of the connection point 20 is lower than the given voltage L. As the resistance value of the squib 5 is normally about several ohms, the voltages of the connection point 19 and the connection point 20 are approximately in the middle between voltages set by the resistor 8 and the resistor 9.

But, when the squib 5 fails open and its resistance value becomes to have more than several hundred ohms, the voltage of the connection point 19 is raised to more than the middle voltage and the voltage of the connection point 20 is lowered to less than the middle voltage. Accordingly, the open failure of the squib 5 can be detected by checking whether or not the voltage $V_+$ of the connection point 19 is larger than the above given voltage H and the voltage $V_-$ of the connection point 20 is smaller than the given voltage L.

When it is determined whether or not the voltage $V_+$ of the connection point 19 is larger than the given voltage H and the voltage $V_-$ of the connection point 20 is smaller than the given voltage L, the process proceeds to step 401 so that the indicator lamp 12 can be lit and the malfunction can be notified. But if this is denied, the process returns to step 200 and again proceeds to each malfunction detection of the block 2000, the block 3000 and the block 4000.

As understood from the above explanation, the abnormality determination of capacitance of the backup capacitor 14 takes place only when the ignition switch 11 is turned on.

On the other hand, the processes of each malfunciton detection of the block 2000, the block 3000 and the block 4000 are repeatedly continued while the ignition switch 11 remains on.

Next, other embodiments of the present invention will be described.

In the above embodiment, the time constant circuit 17 comprising the backup capacitor 10 and the charging resistor 13 is shown as an auxiliary supply means, but the charged battery etc. may be employed. A semiconductor acceleration sensor may be used as the acceleration detection switches 3 and 4.

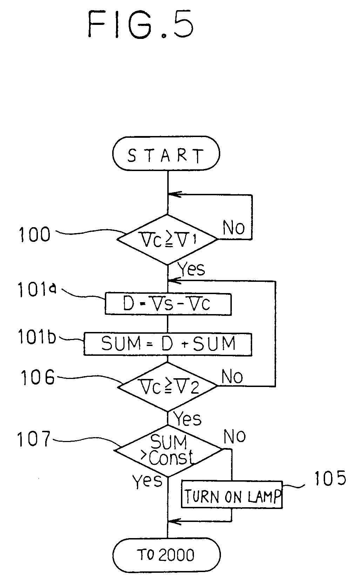

Further, in the flow chart showing operation regarding abnormality determination of capacitance of the microcomputer 2 in FIG. 2, the integration zone as shown in step 102 is a given period, but integration may be done in the zone from a given voltage $V_1$ to a given voltage $V_2$ as shown at step 106 in the flow chart of FIG. 5.

Then, as $V_2 - V_1$ of the second term of the right-hand side of the equation (5) is constant, the division made at step 103 is unnecessary to be made, and decision at step 107 is performed as to whether the value of an arithmetic register SUM is larger than a given constant $C_2$ or not.

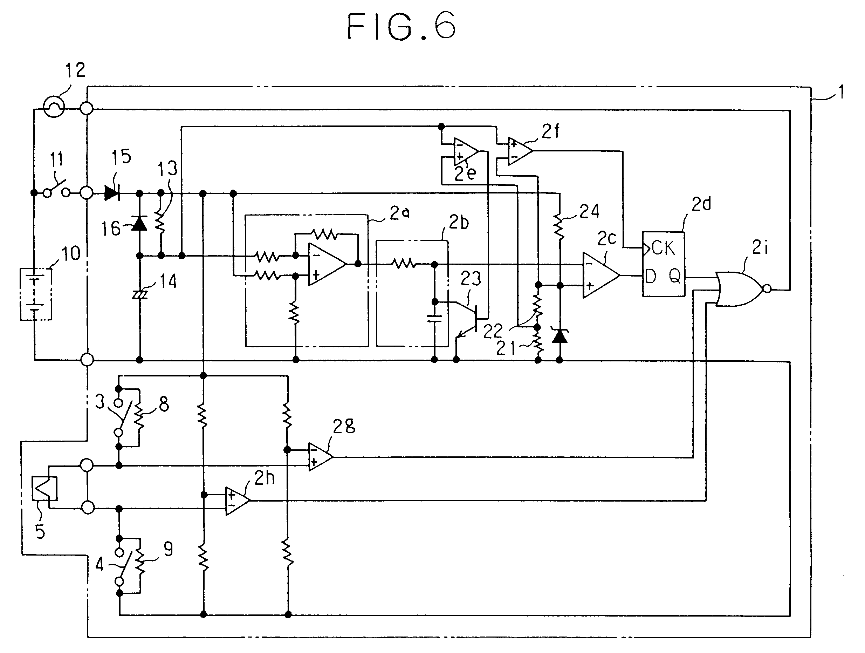

Also, the present invention is able to be embodied using analog circuits. One example is shown in FIG. 6. The parts in FIG. 6 having the same numbers as in FIG. 1 are shown to be the same and equivalent parts as those parts that have the same numbers.

At the apparatus shown in FIG. 6, an integration method in interval from a given voltage $V_1$ to a given voltage $V_2$ as described in some other of the above-mentioned embodiments has been adopted.

In FIG. 6, an integration circuit 2b integrates the output proportional to a voltage difference between both ends of a charging resistor 13, that is, the voltage difference between a backup capacitor 14 and a battery 10 derived from a differential amplifier 2a.

This integration begins after a compactors 2e outputs low level and therefore a transistor 23 is turned off. That is, this comparator 2e and the transistor 23 perform the role of step 100 (Fig. 2).

A comparator 2f supplies its own output to a latch circuit 2d, when the voltage of the backup capacitor 14 exceeds the voltage applied between preset resistor 22 and resistor 24 (corresponding to the above-mentioned given voltage $V_2$).

Therefore, the abnormality of capacitance is determined by the latch circuit 2d of latching the comparison of integration results, small and large, carried out by a comparator 2c at the time when the comparator 2f supplies its own output.

Hence, comparator 2g, 2h shown in the embodiment in Fig. 6 are circuits detecting malfunction of the acceleration detection switches 3 and 4.

The result of this malfunction detection circuit and the result of determination of reduction of the above-mentioned capacitance are outputted to an OR circuit 2i, so that an indicator lamp 12 can be lit when the malfunction has occurred in each result.

## Claims

1. A vehicle occupant protection system comprising means connected or for connection to a battery (10), for actuating vehicle operator protection, auxiliary power supply means (14) chargeable by a battery (10) and dischargeable to supply the electric power to the actuator means (18) when the electric power supply from the battery to the actuator means is interrupted, characterised in that the system further includes determining means (2) for detecting a charging voltage of the auxiliary power supply means (14) and a battery voltage during charging of the auxiliary power supply means (14), for determining a chargeability of the auxiliary power supply means under varying conditions independent of battery voltage variation, and for determining abnormality of the auxiliary power supply means (14) on the basis of the said chargeability.

2. A system according to claim 1, wherein the actuator means (18) comprises means (3,4) for detecting collision of the vehicle.

3. A system according to claim 1 or claim 2, wherein the actuator means (18) comprises a squib (5) for actuating an air bag.

4. A system, according to any preceding claim, wherein the auxiliary power supply means comprises a backup capacitor (14).

5. A system according to claim 4, wherein the determining means (2) comprises means for calculating a difference between the charging voltage and the battery voltage, and means for adding voltage differences calculated by the calculating means over a given period, wherein the added value by the adding means represents the said chargeability of the backup capacitor (14), and abnormality of the backup capacitor (14) is determined on the basis of the said added value.

6. A system according to claim 5, wherein the adding means adds voltage differences calculated by the calculating means for a given period of time after the voltage of the battery has reached a given voltage.

7. A system according to claim 6, wherein the adding means adds voltage differences calculated by the calculation means during the period of the time in which the battery voltage changes from a first given voltage to a second given voltage.

8. A system according to any preceding claim, further comprising means (12) for alerting a vehicle operator to an auxiliary power supply means (14) abnormality determined by the determining means (2).

9. A system according to any preceding claim wherein said protection is provided by an air bag actuated by actuator means (18) such as a squib (5) and further comprising means for supplying the actuating means with current from the said battery (10) insufficient to actuate the said squib (5) when no collision is detected, wherein the determining means (2) comprises checking means for detecting voltage across both ends of the said squib (5) when the said current is being supplied to the squib (5) and for checking abnormality of power supply path to the squib (5).

10. A system according to claim 9, wherein the determining means (2) repeatedly checks for abnormality of the power supplying path after determining a backup capacitor (14) abnormality.

11. A system according to claim 10, wherein the determining means comprises means (12) for alerting a vehicle operator of abnormality by said notifying means when abnormality of the power supply path has been detected.

12. A vehicle occupant protection system as claimed in any of claims 6 to 11 when dependent on claim 5, characterised in that the system comprises actuator means (18) comprising a squib (5) actuating an air bag and collision detecting means (3,4) for detecting collision of said vehicle, the collision detecting means being arranged to close a power supplying line from said battery (10) to said squib (5), so that electric power from said battery (10) is supplied to said squib (5) which causes said squib (5) to actuate said air bag; the backup capacitor (14) is arranged to be charged normally through said power supplying line from said battery (10) and discharged for supplying the backup electric power to said squib (5) through said power supply line when the electric power supply from said battery (10) to said squib (5) has been interrupted; a resistor (13) is provided between said power supplying line and said backup capacitor and constitutes a charging path to said backup capacitor; a diode (16) is provided between said power supplying line and said backup capacitor (14) and constitutes a discharging path of said backup capacitor (14) to said power supplying line; and the determining means (2) is arranged to detect voltage across both ends of said resistor (13) at charging said backup capacitor (14), to detect any difference between both voltages, to add voltage differences through a given period, and to determine any abnormality of said backup capacitor (14) on the basis of the added value.

13. A system according to claim 12, wherein the determining means (2) comprises means for adding the voltage differences during a given period of time after the battery voltage to reach a given voltage to the time when a given time has elapsed.

14. A system according to claim 12, wherein the determining means (2) comprises means for adding voltage differences from the period of time taken for the battery voltage to change from a first given voltage to a second given voltage.

15. A system according to claim 14, further comprising means (2) for alerting a vehicle operator of a backup capacitor abnormality determined by said determining means (2).


**Patentansprüche**

1. Fahrzeuginsassen-Schutzsystem mit einer mit einer Batterie (10) verbundenen oder zur Verbindung mit dieser ausgelegten Einrichtung zur Betätigung des Fahrzeugbenutzer-Schutzes, einer Hilfsspannungs-Versorgungseinrichtung (14), die durch eine Batterie (10) ladbar und zur Zuführung der elektrischen Leistung zur Betätigungseinrichtung (18) bei Unterbrechung der elektrischen Spannungsversorgung der Betätigungseinrichtung durch die Batterie entladbar ist, dadurch gekennzeichnet, daß das System weiterhin eine Bestimmungseinrichtung (2) zum Erfassen einer Ladespannung der Hilfsspannungs-Versorgungseinrichtung (14) und einer Batteriespannung während des Ladens der Hilfsspannungs-Versorgungseinrichtung (14), zum Bestimmen einer Ladbarkeit der Hilfsspannungs-Versorgungseinrichtung unter variierenden Zuständen unabhängig von einer Batteriespannungsschwankung sowie zum Bestimmen einer Abnormalität der Hilfsspannungs-Versorgungseinrichtung (14) auf der Basis der besagten Ladbarkeit aufweist.

2. System nach Anspruch 1, bei dem die Betätigungseinrichtung (18) eine Einrichtung (3, 4) zum Erfassen einer Kollision des Fahrzeugs umfaßt.

3. System nach Anspruch 1 oder Anspruch 2, bei dem die Betätigungseinrichtung (18) eine Zündladung (5) zum Betätigen eines Airbags aufweist.

4. System nach einem der vorhergehenden Ansprüche, bei dem die Hilfspannungs-Versorgungseinrichtung einen Unterstützungskondensator (14) umfaßt.

5. System nach Anspruch 4, bei dem die Bestimmungseinrichtung (2) eine Einrichtung zum Berechnen einer Differenz zwischen der Ladespannung und der Batteriespannung, sowie eine Einrichtung zum Addieren der durch die Berechnungseinrichtung berechneten Spannungsdifferenzen über eine gegebene Zeitdauer aufweist, wobei der durch die Addiereinrichtung gebildete, addierte Wert die besagte Ladbarkeit des Unterstützungskondensators (14) repräsentiert, und wobei eine Abnormalität des Unterstützungskondensators (14) auf der Basis des besagten addierten Werts bestimmt wird.

6. System nach Anspruch 5, bei dem die Addiereinrichtung Spannungsdifferenzen addiert, die durch die Berechnungseinrichtung für eine gegebene Zeitdauer berechnet wurden, nachdem die Spannung der Batterie eine gegebene Spannung erreicht hat.

7. System nach Anspruch 6, bei dem die Addiereinrichtung Spannungsdifferenzen addiert, die durch die Berechnungseinrichtung während der Zeitperiode berechnet wurden, in der sich die Batteriespannung von einer ersten gegebenen Spannung zur einer zweiten gegebenen Spannung verändert.

8. System nach einem der vorhergehenden Ansprüche, das weiterhin eine Einrichtung (12) aufweist, die dazu dient, einen Fahrzeugbenutzer auf eine durch die Bestimmungseinrichtung (2) bestimmte Abnormalität der Hilsspannungs-Versorgungseinrichtung (14) aufmerksam zu machen.

9. System nach einem der vorhergehenden Ansprüche, bei dem der Schutz durch einen Airbag bereitgestellt wird, der durch die Betätigungseinrichtung (18) wie etwa eine Zündladung (15) betätigt wird, und das weiterhin eine Einrichtung zum Versorgen der Betätigungseinrichtung mit einem von besagter Batterie (10) zugeführten Strom aufweist, der zur Betätigung der Zündladung (5) bei Nicht-Erfassung einer Kollision nicht ausreichend ist, wobei die Bestimmungseinrichtung (2) eine Prüfeinrichtung zum Erfassen der Spannung an beiden Anschlüssen der Zündladung (5), wenn der besagte Strom zur Zündladung (5) zugeführt wird, und zum Überprüfen einer Abnormalität des Spannungsversorgungspfads zur Zündladung (5) aufweist.

10. System nach Anspruch 9, bei dem die Bestimmungseinrichtung (2) eine Abnormalität des Spannungsversorgungspfads wiederholt nach Bestimmung einer Abnormalität eines Unterstützungskondensators (14) überprüft.

**11.** System nach Anspruch 10, bei dem die Bestimmungseinrichtung eine Einrichtung (12) aufweist, die dazu dient, einen Fahrzeugbenutzer mittels der Anzeigeeinrichtung auf eine Abnormalität aufmerksam zu machen, wenn eine Abnormalität des Spannungsversorgungspfads erfaßt wurde.

**12.** Fahrzeuginsassen-Schutzsystem nach einem der Ansprüche 6 bis 11 unter Rückbeziehung auf Anspruch 5, dadurch gekennzeichnet, daß das System eine Betätigungseinrichtung (18) mit einer einen Airbag betätigenden Zündladung (5) und eine Kollisionserfassungseinrichtung (3, 4) zum Erfassen einer Kollision des Fahrzeugs aufweist, wobei die Kollisionserfassungseinrichtung derart ausgelegt ist, daß sie eine Spannungsversorgungsleitung von der Batterie (10) zur Zündladung (5) schließt, so daß elektrische Leistung von der Batterie (10) zur Zündladung (5) gespeist wird und hierdurch die Zündladung (5) zur Zündung des Airbags veranlaßt wird; daß der Unterstützungskondensator (14) so ausgelegt ist, daß er normalerweise über die Spannungsversorgungsleitung von der Batterie (10) geladen wird und zur Zuführung der unterstützenden elektrischen Leistung zur Zündladung (5) über die Spannungsversorgungsleitung entladen wird, wenn die elektrische Spannungsversorgung von der Batterie (10) zur Zündladung (5) unterbrochen wurde; daß ein Widerstand (13) zwischen der Spannungsversorgungsleitung und dem Unterstützungskondensator vorgesehen ist und einen Ladepfad für den Unterstützungskondensator bildet; daß eine Diode (16) zwischen der Spannungsversorgungsleitung und dem Unterstützungskondensator (14) vorgesehen ist und einen Entladepfad des Unterstützungskondensators (14) zur Spannungsversorgungsleitung bildet; und daß die Bestimmungseinrichtung (2) so ausgelegt ist, daß sie eine Spannung an beiden Anschlüssen des Widerstands (13) beim Laden des Unterstützungskondensators (14) für die Erfassung irgendeiner Differenz zwischen beiden Spannungen, für die Addierung von Spannungsdifferenzen über eine gegebene Zeitdauer und für die Bestimmung irgendeiner Abnormalität des Unterstützungskondensators (14) auf der Basis des addierten Werts erfaßt.

**13.** System nach Anspruch 12, bei dem die Bestimmungseinrichtung (2) eine Einrichtung zum Addieren der Spannungsdifferenzen während einer gegebenen Zeitspanne nach Erreichen einer gegebenen Spannung durch die Batteriespannung bis zum Zeitpunkt, wenn eine gegebene Zeitdauer verstrichen ist, aufweist.

**14.** System nach Anspruch 12, bei dem die Bestimmungseinrichtung eine Einrichtung zum Addieren von Spannungsdifferenzen von dem Zeitintervall aufweist, das die Batteriespannung für die Veränderung von einer ersten gegebenen Spannung bis zu einer zweiten gegebenen Spannung braucht.

**15.** System nach Anspruch 14, das weiterhin eine Einrichtung (2) aufweist, die dazu dient, einen Fahrzeugbenutzer auf eine durch die Bestimmungseinrichtung (2) bestimmte Abnormalität eines Unterstützungskondensators aufmerksam zu machen.

## Revendications

**1.** Système de protection d'occupant d'un véhicule comprenant un moyen connecté ou pour connexion à une batterie (10), pour actionner la protection du conducteur du véhicule, un moyen d'alimentation auxiliaire (14) chargeable par une batterie (10) et déchargeable pour délivrer l'énergie électrique au moyen actionneur (18) lorsque l'énergie électrique provenant de la batterie vers le moyen actionneur est interrompue, caractérisé en ce que le système comporte de plus un moyen de détermination (2) pour détecter une tension de charge du moyen d'alimentation auxiliaire (14) et une tension de batterie pendant la charge du moyen d'alimentation auxiliaire (14), pour déterminer la capacité de charge du moyen d'alimentation auxiliaire pendant des conditions variables indépendantes de la variation de la tension de la batterie, et pour déterminer l'anomalie du moyen d'alimentation auxiliaire (14) sur la base de la capacité de charge.

**2.** Système selon la revendication 1, dans lequel le moyen actionneur (18) comprend des moyens (3, 4) pour détecter la collision du véhicule.

**3.** Système selon la revendication 1 ou la revendication 2, dans lequel le moyen actionneur (18) comprend un détonateur (5) pour actionner un air bag.

**4.** Système selon l'une quelconque des revendications précédentes, dans lequel le moyen d'alimentation auxiliaire comprend un condensateur de secours (14).

5. Système selon la revendication 4, dans lequel le moyen de détermination (2) comprend un moyen pour calculer une différence entre la tension de charge et la tension de la batterie, et un moyen pour ajouter les différences de tension calculées par le moyen de calcul sur un intervalle de temps donné, dans lequel la valeur ajoutée par le moyen d'addition représente la capacité de charge du condensateur de secours (14), et l'anomalie du condensateur de secours (14) est déterminée sur la base de la valeur ajoutée.

6. Système selon la revendication 5, dans lequel le moyen d'addition ajoute les différences de tension calculées par le moyen de calcul pendant un intervalle de temps donné après que la tension de la batterie ait atteint une tension donnée.

7. Système selon la revendication 6, dans lequel la moyen d'addition ajoute les différences de tension calculées par le moyen de calcul pendant l'intervalle de temps pendant lequel la tension de batterie passe d'une première tension donnée à une seconde tension donnée.

8. Système selon l'une quelconque des revendications précédentes, comprenant de plus un moyen (12) pour avertir un conducteur du véhicule qu'une anomalie du moyen d'alimentation auxiliaire (14) a été déterminée par le moyen de détermination (2).

9. Système selon l'une quelconque des revendications précédentes, dans lequel la protection est assurée par un air bag actionné par un moyen actionneur (18) tel qu'un détonateur (5), et comprend de plus un moyen pour appliquer au moyen d'actionnement un courant provenant de la batterie (10) insuffisant pour actionner le détonateur (5) lorsqu'aucune collision n'est détectée, dans lequel le moyen de détermination (2) comprend un moyen de vérification pour détecter la tension aux bornes dudit détonateur (5) lorsque le courant est appliqué au détonateur (5) et pour vérifier l'anomalie du trajet d'alimentation du détonateur (5).

10. Système selon la revendication 9, dans lequel le moyen de détermination (2) vérifie de manière répétée l'anomalie du trajet d'alimentation après détermination d'une anomalie du condensateur de secours (14).

11. Système selon la revendication 10, dans lequel le moyen de détermination comprend un moyen (12) pour avertir un conducteur du véhicule de l'anomalie par le moyen d'avertissement lorsqu'une anomalie du trajet d'alimentation a été détectée.

12. Système de protection d'occupant d'un véhicule selon l'une quelconque des revendications 6 à 11 lorsque dépendantes de la revendication 5, caractérisé en ce que le système comprend un moyen actionneur (18) comprenant un détonateur (5) actionnant un air bag et un moyen de détection de collision (3, 4) pour détecter la collision du véhicule, le moyen de détection de collision étant disposé pour fermer une ligne d'alimentation de la batterie (10) vers le détonateur (5), de sorte que l'énergie électrique provenant de la batterie (10) est délivrée au détonateur (5) qui amène le détonateur (5) à actionner l'air bag ; le condensateur de secours (14) est disposé pour être normalement chargé par l'intermédiaire de la ligne d'alimentation provenant de la batterie (10) et déchargé pour appliquer l'énergie électrique de secours au détonateur (5) par l'intermédiaire de la ligne d'alimentation lorsque l'alimentation électrique provenant de la batterie (10) vers le détonateur (5) a été interrompue ; une résistance (13) est prévue entre la ligne d'alimentation et le condensateur de secours et constitue un trajet de charge vers le condensateur de secours, une diode (16) est prévue entre la ligne d'alimentation et le condensateur de secours (14) et constitue un trajet de décharge du condensateur de secours (14) vers la ligne d'alimentation ; et le moyen de détermination (2) est disposé pour détecter la tension aux bornes de la résistance (13) pendant la charge du condensateur de secours (14) pour détecter toute différence entre les deux tensions, afin d'ajouter les différences de tension pendant un intervalle de temps donné, et pour déterminer toute anomalie du condensateur de secours (14) sur la base de la valeur ajoutée.

13. Système selon la revendication 12, dans lequel le moyen de détermination (2) comprend un moyen pour ajouter les différences de tension pendant l'intervalle donné après que la tension de la batterie atteigne une tension donnée lorsque le temps donné s'est écoulé.

14. Système selon la revendication 12, dans lequel le moyen de détermination (2) comprend un moyen pour ajouter les différences de tension à partir de l'intervalle de temps pris par la tension de la batterie pour passer d'une première tension donnée à une seconde tension donnée.

15. Système selon la revendication 14, comprenant de plus un moyen (2) pour avertir un conducteur de véhicule de l'anomalie d'un condensateur de secours déterminé par le moyen de détermination (2).

# FIG.1

# FIG.2

START

100 — $Vc \geqq V1$ — NO

Yes

101a — $D = Vs - Vc$

101b — $SUM = D + SUM$

102 — $(t2-t1) = C1$ — No

Yes

103 — $DAT = SUM/(V2-V1)$

104 — $dat > C2$ — No

Yes

TURN ON LAMP — 105

TO 2000

# FIG.3

START

1000 — ABNORMARITY DETERMINATION

2000 —

200 $\nabla_+ > H$ and $\nabla_- > H$ — Yes

No — 201 TURN ON LAMP

3000 —

300 $\nabla_+ < L$ and $\nabla_- < L$ — Yes

No — 301 TURN ON LAMP

4000 —

400 $\nabla_+ > H$ and $\nabla_- < L$ — Yes

No — 401 TURN ON LAMP

# FIG.4

$\nabla_s(t)$

$\nabla$

$\nabla_2$

$\nabla_1$

$\nabla_c(t)$

$t_1$        $t_2$        $t$

# FIG.5

FIG.6